# EUROPÄISCHE PATENTSCHRIFT

(11) **EP 3 085 211 B1**
(45) Veröffentlichungstag und Bekanntmachung des Hinweises auf die Patenterteilung: **10.06.2020**
(21) Anmeldenummer: 14795651.0
(22) Anmeldetag: 10.11.2014
(51) Int. Cl.: H05K 3/32, H05K 3/34, H05K 5/00, H05K 1/11

(54) **ELEKTRONISCHES STEUERMODUL UND VERFAHREN ZUR HERSTELLUNG EINES ELEKTRONISCHEN STEUERMODULS**
ELECTRONIC CONTROL MODULE AND METHOD FOR PRODUCING AN ELECTRONIC CONTROL MODULE
MODULE DE COMMANDE ÉLECTRONIQUE ET PROCÉDÉ PERMETTANT DE PRODUIRE UN MODULE DE COMMANDE ÉLECTRONIQUE

(30) Priorität: 20.12.2013 DE 102013227003
(43) Veröffentlichungstag der Anmeldung: 26.10.2016
(73) Patentinhaber: Robert Bosch GmbH, 70442 Stuttgart (DE)
(72) Erfinder: LISKOW, Uwe, 71679 Asperg (DE)
(86) Internationale Anmeldenummer: PCT/EP2014/074189
(87) Internationale Veröffentlichungsnummer: WO 2015/090732

(56) Entgegenhaltungen:
- WO-A1-2008/031366
- DE-A1-102011 083 576
- JP-A- H05 160 550

## Beschreibung

### Stand der Technik

Die Erfindung betrifft ein elektronisches Steuermodul, insbesondere für eine Getriebesteuerung und ein Verfahren zur Herstellung eines solchen elektronischen Steuermoduls.

In der Kraftfahrzeugtechnik werden zur Getriebeansteuerung elektronische Steuermodule verwandt, die am Getriebe und im Getriebefluid angeordnet werden können. Die Steuermodule können beispielsweise elektrische Bauelemente wie Stecker, Sensoren, Aktuatoren, wenigsten ein gekapseltes Steuergerät (TCU, Transmission Control Unit) und gegebenenfalls weitere Komponenten aufweisen, die an einem zentralen Träger befestigt sind und dem Getriebefluid ausgesetzt sind. Die Anordnung im Getriebefluid stellt hohe Herausforderungen an die Aufbau- und Verbindungstechnik der Baukomponenten auf dem Träger des elektronischen Steuermoduls, da die elektrischen Verbindungen hohen Temperaturwechselbelastungen sowie dem Getriebefluid mit darin im ungünstigen Fall enthaltenen Metallspänen wiederstehen können müssen. Als Träger der elektrischen Verbindungstechnik werden im Stand der Technik umspritzte Stanzgitter sowie starre Leiterplatten oder flexible Leiterplatten (sogenannte Flexfolien) eingesetzt.

Eine gängige Kontaktierungstechnik von elektrischen Bauelementen auf Leiterplatten besteht darin, elektrische Anschusselemente der Bauelemente in Durchsteckmontage in Kontaktierungsöffnungen der Leiterplatte einzulöten. So zeigen beispielsweise die US 2009/0176402 A1 und die US 2008/0144260 A1 Steckerteile deren Anschlusselemente in Durchkontaktierungen der Leiterplatte eingelötet sind. Nachteilig bei dieser Verbindungstechnik für die Anwendung im Getriebeöl ist, dass die Anschlusselemente bis auf die Unterseite der Leiterplatte durchragen und daher an der Unterseite Abdeckungen und Schutzmaßnahmen erforderlich sind, um eine Ablagerung von Metallspänen und daraus resultierende Kurzschlüsse zu verhindern.

In jüngster Zeit wurden elektronische Steuermodule für die Getriebesteuerung entwickelt, die vorzugsweise eine starre Leiterplatte als Träger der elektrischen Verbindungstechnik verwenden, wobei elektrische Bauelemente in Oberflächenmontage auf die Leiterplatte aufgebracht werden können. So ist beispielsweise aus der DE 10 2011 088 335 A1 ein elektronisches Steuermodul mit einer auf einer Trägerplatte aufgebrachten Leiterplatte bekannt. Ein elektrisches SMD-Bauelement weist Anschlusselemente mit parallel zur Bestückungsseite der Leiterplatte verlaufenden Anschlussabschnitten auf, die mit korrespondierenden Kontaktflächen auf der Bestückungsseite der Leiterplatte verlötet sind. Die in der DE 10 2011 088 335 A1 als Lötflächen bezeichneten Kontaktflächen sind über VIAs (Vertical interconnected access), die auch als Zwischenverbinder oder Durchkontaktierungen bezeichnet werden, mit Leiterbahnen im inneren der Leiterplatte elektrische verbunden. Die DE 10 2011 088 335 A1 schlägt einen Niederhalter vor, um die Anschlussabschnitte während des Lötvorgangs an die Kontaktfläche anzudrücken und ein Zurückfedern des Anschlussabschnitts aus dem flüssigen Lot zu verhindern.

Ferner ist aus der DE 2011 088 620 A1 eine elektronische Schaltung für ein Automatikgetriebe eines Kraftfahrzeuges bekannt, bei dem ein Steckergehäuse mittels eines Rastelementes an einer Leiterplatte festgelegt ist und ein Anschlusspin des Steckergehäuses einen Drahtabschnitt aufweist, der in eine metallisierte Durchkontaktierung der Leiterplatte eingeführt ist und darin verlötet ist. Außerdem ist aus der DE 100 62 962 A1 bekannt, große elektrische Bauelemente in einen Halterahmen einzusetzen, und das Bauelement zusammen mit dem Halterahmen auf die Leiterplatte aufzubringen, wobei an dem Halterahmen angeordnete Anschlusspins durch Kontaktierungsöffnungen in die Leiterplatte eingeführt werden und mit dieser verlötet werden.

Aus der DE 10 2011 083 576 A1 ist eine Vorrichtung zur Aussenkontaktierung eines Schaltungsmoduls bekannt, bei der das Schaltungsmodul mindestens einen Schaltkreis, ein Gehäuse und mehrere Außenkontakte umfasst, wobei der mindestens eine Schaltkreis vollständig in dem Gehäuse angeordnet ist und die mehreren Außenkontakte aus dem Gehäuse herausgeführt sind. Die Vorrichtung weist einen als Rahmen ausgeführten Grundkörper und mindestens ein Kontaktelement mit zwei Kontaktbereichen auf, wobei ein erster Kontaktbereich des jeweiligen Kontaktelements als Kontaktpartner für mindestens einen Außenkontakt des Schaltungsmoduls ausgeführt ist, und ein zweiter Kontaktbereich als Kontaktpartner für eine weitere Kontaktierung ausgeführt ist, welche mittels einer vorgegebenen Verbindungsart realisierbar ist.

### Offenbarung der Erfindung

Die Erfindung bezieht sich auf ein elektronisches Steuermodul, bei dem an der Leiterplatte wenigstens ein Adapter angeordnet ist, der unabhängig von dem wenigstens einen elektrischen Bauelement, als separates Teil auf der Leiterplatte angeordnet ist und der einen außerhalb der wenigstens einen Kontaktfläche an der Leiterplatte befestigten Haltekörper und wenigstens einen an dem Haltekörper angeordneten metallischen Steg mit einem parallelen zur Bestückungsseite der Leiterplatte verlaufenden Kontaktabschnitt aufweist, wobei der Kontaktabschnitt des wenigstens einen metallischen Stegs und der Anschlussabschnitt des wenigstens einen Anschlusselementes in einer Richtung senkrecht zur Leiterplatte gesehen in einem Überdeckungsbereich aufeinander liegend angeordnet sind und in dem Überdeckungsbereich miteinander verschweißt sind, und dass der wenigstens eine metallische Steg oder das wenigstens eine Anschlusselement mittels eines auf die wenigstens eine Kontaktfläche aufgebrachten elektrisch leitenden Werkstoffs mit der wenigstens einen Kontaktfläche elektrisch kontaktiert sind. Erfindungsgemäß ist vorgesehen, dass
- sich der Anschlussabschnitt (25) des wenigstens einen Anschlusselementes (24) in direktem Kontakt mit dem elektrisch leitenden Werkstoff (42) auf der wenigstens einen Kontaktfläche (13a) der Leiterplatte (5) befindet und dass der Kontaktabschnitt (35) des wenigstens einen metallischen Steges (34) auf der von der wenigstens einen Kontaktfläche (13a) abgewandten Seite des Anschlussabschnitts (25) auf diesem aufliegt oder
- dass sich der Kontaktabschnitt (35) des wenigstens einen metallischen Steges (34) in direktem Kontakt mit dem elektrisch leitenden Werkstoff (42) auf der wenigstens einen Kontaktfläche (13a) der Leiterplatte (5) befindet und dass der Anschlussabschnitt (25) des wenigstens einen Anschlusselementes (24) auf der von der wenigstens einen Kontaktfläche (13a) abgewandten Seite des Kontaktabschnitts (35) auf diesem aufliegt.

Jeder Adapter kann einen oder mehrere metallische Stege aufweisen, die dann jeweils den Anschlusselementen von einem oder mehreren elektrischen Bauelementen zugeordnet sind. Auf der Leiterplatte können mehrere Adapter völlig unabhängig von den elektrischen Bauelementen bestückt werden. Insbesondere kann die Aufbringung des Adapters vor oder nach der Aufbringung der elektrischen Bauelemente erfolgen. Jeder Adapter weist einen Haltekörper auf, mit dem er außerhalb des mit den Kontaktflächen versehenen Leiterplattenbereichs mechanisch an der Leiterplatte befestigt werden kann. Die Erfindung ermöglicht somit ein neues Kontaktierungskonzept für oberflächenmontierte elektrische Bauelemente, die mit ihren Anschlusselementen mit den zugeordneten metallischen Stegen der Adapter verschweißt werden können. Die elektrische Verbindung zur Leiterplatte erfolgt mittels eines elektrisch leitenden Werkstoffs auf der Kontaktfläche der Leiterplatte, der mit dem Anschlusselement oder mit dem metallischen Steg elektrisch verbunden wird.

Die Erfindung betrifft weiter ein Verfahren zur Herstellung eines elektronischen Steuermoduls nach den nebengeordneten Verfahrensansprüchen, wobei zwei alternative Verfahren möglich sind, je nachdem, ob die Anschlusselemente der elektrischen Bauelemente oder die metallischen Stege der Kontaktelemente der Adapter mit den Kontaktflächen der Leiterplatte über den elektrisch leitenden Werkstoff direkt verbunden werden sollen. Insbesondere sind auch Mischformen der beiden Verfahren möglich, bei denen einzelne Kontaktierungen nach dem einen Verfahren und andere Kontaktierungen nach dem anderen Verfahren durchgeführt werden.

Vorteilhaft können die zur Steuerschaltung gehörenden Bauelemente der TCU in einer Vorfertigung auf die Leiterplatte aufgebracht werden und über Bonddrähte mit den Leiterbahnen kontaktiert werden. Anschließend kann die Bestückung weiterer elektrischer Bauelemente, wie Stecker und Sensoren in einer schnell getakteten Fertigungslinie durchgeführt werden, ohne dass weitere thermische Einzelprozesse oder Lötschritte auf der Unterseite der Leiterplatte notwendig werden.

### Vorteile der Erfindung

Für die Anwendung im Getriebeöl ist es vorteilhaft, wenn die elektrischen Anschlusselemente in einem Schweißvorgang mit Kontakten auf der Leiterplatte elektrisch verbunden werden können und keine Anschlusspins bis auf die von der Bestückungsseite der Leiterplatte abgewandte Unterseite der Leiterplatte durchragen. Hierdurch wird vorteilhaft Bauraumbedarf auf der Leiterplatte durch Entfall der Durchsteckverbindungen eingespart. Erfindungsgemäß ist vorteilhaft ein Schweißvorgang vorgesehen, um ein Anschlusselement eines auf die Bestückungsseite der Leiterplatte bestückten elektrischen Bauelements mit einem metallischen Steg des Adapters zu verschweißen und dadurch vorteilhaft eine stabile und zuverlässige elektrische Verbindung zwischen dem Anschlusselement und dem Steg zu gewährleisten. Besonders vorteilhaft ist die Ausrichtung des Anschlussabschnitts des Anschlusselementes und des Kontaktabschnitts des metallischen Steges parallel zur Bestückungsseite der Leiterplatte, wobei der Kontaktabschnitt des wenigstens einen metallischen Stegs und der Anschlussabschnitt des wenigstens einen Anschlusselementes in einer Richtung senkrecht zur Leiterplatte gesehen in einem Überdeckungsbereich aufeinander liegend angeordnet sind. Durch diese Maßnahme wird erreicht, dass mit einem Laser senkrecht zur Bestückungsseite der Leiterplatte geschweißt werden kann. Aufgrund des räumlich ausgedehnten Überdeckungsbereiches ist der Kontaktbereich zwischen Kontaktabschnitt und Anschlussabschnitt robust gegenüber Lagetoleranzen des elektrischen Bauelements. Die Verschweißung erfolgt vorzugsweise mit dem Laser in dem Überdeckungsbereich.

Erfindungsgemäß erfolgt die elektrische Anbindung des wenigstens einen elektrischen Bauelementes an die Leiterplatte dadurch, dass entweder der wenigstens eine metallische Steg oder das wenigstens eine Anschlusselement, je nachdem was über der Kontaktfläche angeordnet ist, mittels eines auf die wenigstens eine Kontaktfläche aufgebrachten elektrisch leitenden Werkstoffs mit der wenigstens einen Kontaktfläche elektrisch kontaktiert ist. Als elektrisch leitender Werkstoff kann beispielsweise Lot oder ein aushärtbarer Kleber verwandt werden.

Besonders vorteilhaft wird durch die Schweißverbindung zwischen dem wenigsten einen Anschlusselement und dem wenigstens einen metallischen Steg und durch die von der elektrischen Verbindung mit der Leiterplatte unabhängige mechanischen Festlegung des Adapters an der Leiterplatte erreicht, dass die mittels des elektrisch leitenden Werkstoffs hergestellte elektrische Verbindung zu der wenigstens einen Kontaktfläche der Leiterplatte entlastet wird. Thermische Spannungen und Vibrationsbelastungen können daher über die stabile mechanische Befestigung des Adapters abgefangen werden, so dass Querkräfte und Vertikalkräfte von der mittels des elektrisch leitenden Werkstoffs hergestellten Verbindung abgehalten werden. Die Kräfte werden über den Haltekörper des Adapters vorteilhaft von der Leiterplatte aufgenommen. Insbesondere für den Fall, dass als elektrisch leitender Werkstoff Lot verwandt wird, kann somit eine Entlastung der Lötstelle erreicht werden.

Vorteilhaft werden das wenigstens eine elektrische Bauelement und der wenigstens eine Adapter unabhängig voneinander auf die Leiterplatte aufgebracht. Dabei ist es möglich, zunächst das elektrische Bauelement auf die Leiterplatte zu bestücken, so dass sich der Anschlussabschnitt des wenigstens einen Anschlusselementes in direktem Kontakt mit dem elektrisch leitenden Werkstoff auf der wenigstens einen Kontaktfläche der Leiterplatte befindet. Bei der anschließenden Anordnung des Adapters kann der Kontaktabschnitt des wenigstens einen metallischen Steges auf der von der wenigstens einen Kontaktfläche abgewandten Seite des Anschlussabschnitts auf diesem aufliegen. Ebenso ist es aber auch möglich, zunächst den Adapter auf die Leiterplatte zu bestücken, so dass sich der Kontaktabschnitt des wenigstens einen metallischen Steges in direktem Kontakt mit dem elektrisch leitenden Werkstoff auf der wenigstens einen Kontaktfläche der Leiterplatte befindet, und anschließend das elektrische Bauelement auf die Leiterplatte aufzubringen, so dass der Anschlussabschnitt des wenigstens einen Anschlusselementes auf der von der wenigstens einen Kontaktfläche abgewandten Seite des Kontaktabschnitts auf diesem aufliegt. In beiden Fällen kann der jeweils von der Kontaktfläche abgewandte Verbindungspartner eine Vorspannkraft auf den zwischen ihm und der Kontaktfläche angeordneten anderen Kontaktpartner ausüben.

Vorteilhafte Ausgestaltungen und Weiterbildungen der Erfindung werden durch die in den abhängigen Ansprüchen enthaltenden Merkmale ermöglicht.

Vorteilhaft weist das elektronische Steuermodul einen Adapter mit einem Haltekörper auf, der wenigstens einen in eine Einführungsöffnung der Leiterplatte eingeführten Befestigungszapfen aufweist. Der Befestigungszapfen kann beispielsweise in die Einführungsöffnung der Leiterplatte eingeklemmt werden. Der Befestigungszapfen verschließt dabei gleichzeitig die Einführungsöffnung in der Leiterplatte. Da der Befestigungszapfen in der Einführungsöffnung im Unterschied zu einem Pin in einer Durchkontaktierung keine elektrische Funktion aufweist, entstehen an der Unterseite der Leiterplatte vorteilhaft keine Öffnungen, die elektrisch leitende Teile enthalten. Der Befestigungszapfen kann vorteilhaft einstückig mit dem Haltekörper ausgebildet sein.

Der Haltekörper des wenigstens einen Adapters kann aus Kunststoff gefertigt sein. Der Adapter kann beispielswiese preisgünstig als einfaches Spritzgussteil hergestellt werden, bei dem der metallische Steg mit dem Kunststoff des Haltekörpers umspritzt wird. Der Befestigungszapfen des Halterkörpers kann gleichzeitig mit der Umspritzung des metallischen Steges an dem Halterkörper hergestellt werden.

In einem besonders einfachen Ausführungsbeispiel ragt der wenigstens eine metallische Steg zumindest an einer Seite des Halterkörpers, parallel zur Leiterplatte aus dem Haltekörper seitlich heraus. Mit seinem anderen, nicht freien Ende ist der metallische Steg in dem Haltekörper festgelegt. Wichtig ist die Ausrichtung des Steges in der Endstellung des Adapters, wenn dieser an der Leiterplatte festgelegt ist. So ist es möglich, dass der metallische Steg anfänglich nicht genau senkrecht zum Befestigungszapfen gestellt ist und leicht schräg zur Bestückungsseite der Leiterplatte gestellt ist, dann aber beim Einschieben des Befestigungszapfens in die Einführungsöffnung in der Endlage an die Kontaktfläche oder an das Anschlusselement eines elektrischen Bauelementes anstößt und parallel zur Bestückungsseite der Leiterplatte elastisch zurückgebogen wird. Durch den metallischen Steg wird dann gleichzeitig eine in Richtung Kontaktfläche wirkende Vorspannkraft aufgebracht.

Vorteilhaft ist die wenigstens eine Kontaktfläche der Leiterplatte in einem Ausführungsbeispiel in einer Richtung senkrecht zur Leiterplatte gesehen unterhalb des Überdeckungsbereichs von Kontaktabschnitt und Anschlussabschnitt angeordnet. Hierdurch kann vorteilhaft erreicht, dass beim Laserschweißen des Kontaktabschnitts und des Anschlussabschnitts gleichzeitig auch ein Lotdepot auf der Kontaktfläche durch den Wärmeeintrag des Schweißvorgangs besonders einfach aufgeschmolzen werden kann. Außerdem wird die Lötstelle durch die direkt darüber angeordnete Schweißstelle optimal entlastet.

Der Schweißvorgang ist besonders zuverlässig durchführbar, wenn der Kontaktabschnitt des wenigstens einen Steges und der Anschlussabschnitt des wenigstens einen Anschlusselementes durch Metallstreifen mit rechteckförmigen Querschnitt gebildet werden, die zumindest im Überdeckungsbereich flach aufeinander liegend angeordnet sind.

Vorteilhaft ist weiterhin ein Herstellungsverfahren des erfindungsgemäßen elektronischen Steuermodules mit folgenden Schritten:
- Bereitstellen einer Leiterplatte mit einer Bestückungsseite, auf der wenigstens eine Kontaktfläche angeordnet ist,
- Aufbringen eines elektrisch leitenden Werkstoffs auf die wenigstens eine Kontaktfläche,
- Anordnen wenigstens eines Adapters auf der Leiterplatte, wobei der wenigstens eine Adapter einen Haltekörper zur Befestigung an der Leiterplatte außerhalb der wenigstens einen Kontaktfläche und wenigsten einen an dem Haltekörper angeordneten metallischen Steg mit einem zumindest in der auf der Leiterplatte befestigten Endstellung des Adapters parallel zur Bestückungsseite der Leiterplatte verlaufenden Kontaktabschnitt aufweist, wobei der wenigsten eine metallische Steg unmittelbar über der wenigstens einen mit dem elektrisch leitenden Werkstoff versehenen Kontaktfläche angeordnet wird,
- Anordnen wenigstens eines elektrischen Bauteils auf der mit dem wenigstens einen Adapter versehenen Leiterplatte, wobei das wenigstens eine elektrische Bauteil wenigstens ein elektrisches Anschlusselement aufweist, das einen parallel zur Bestückungsseite der Leiterplatte verlaufenden Anschlussabschnitt aufweist, wobei der Anschlussabschnitt in einem Überdeckungsbereich unmittelbar auf dem Kontaktabschnitt aufliegend angeordnet wird,
- Verschweißen des Anschlussabschnitts mit dem Kontaktabschnitt,
wobeiwährend des Schrittes des Verschweißens des Anschlussabschnitts mit dem Kontaktabschnitt gleichzeitig der metallische Steg mit der Kontaktfläche durch den Wärmeeintrag des Schweißvorgangs verlötet wird.

Bei diesem Verfahren wird durch die Aufbringung des Adapters vorteilhaft eine Schweißfläche (durch den metallischen Steg) auf der Leiterplatte erzeugt, die in elektrischer Verbindung mit der Kontaktfläche der Leiterplatte steht. Beim Schweißen mit beispielsweise einem Laser erfolgt ein Aufschmelzen des Anschlussabschnitts in einem engen Bereich und ein Aufschmelzen des darunter liegenden metallischen Steges, die dadurch verbunden werden. Der Steg verhindert zuverlässig ein Eindringen des Lasers in die Kontaktfläche oder das Material der Leiterplatte, da der Anschlussabschnitt nicht direkt mit der Kontaktfläche verschweißt wird. Da beim Laserschweißen nur lokal Wärme zugeführt wird und kein großflächiges Erwärmen und Abkühlen erfolgt, entstehen während der Fertigung kaum Spannungen. Vorteilhaft ist hier der relativ kurze Abstand der Schweißstelle zu dem mechanischen Haltepunkt des Adapters, so dass zwischen dem Haltepunkt, also beispielsweise dem in die Einführöffnung eingreifendem Befestigungszapfen und der Schweißstelle sowie der elektrischen Verbindung zur Kontaktfläche keine großen mechanischen Spannungen auftreten.

Vorteilhaft ist weiterhin ein Herstellungsverfahren des erfindungsgemäßen elektronischen Steuermoduls, mit folgenden Schritten:
- Bereitstellen einer Leiterplatte mit einer Bestückungsseite, auf der wenigstens eine Kontaktfläche angeordnet ist,
- Aufbringen eines elektrisch leitenden Werkstoffs auf die wenigstens seine Kontaktfläche,
- Anordnen wenigstens eines elektrischen Bauteils auf der Leiterplatte, wobei das wenigstens eine elektrische Bauteil wenigstens ein elektrisches Anschlusselement aufweist, wobei das einen parallel zur Bestückungsseite der Leiterplatte verlaufenden Anschlussabschnitt aufweist, wobei das wenigstens eine Anschlusselement unmittelbar über der mit dem elektrisch leitenden Werkstoff versehenen Kontaktfläche angeordnet wird,
- Anordnen wenigstens eines Adapters auf der mit dem wenigstens einen elektrischen Bauteil versehen Leiterplatte, wobei der wenigstens eine Adapter einen Haltekörper zur Befestigung an der Leiterplatte außerhalb der wenigstens einen Kontaktfläche und wenigstens einen an dem Haltekörper angeordneten metallischen Steg mit einem zumindest in der auf der Leiterplatte befestigten Endstellung des Adapters parallel zur Bestückungsseite der Leiterplatte verlaufenden Kontaktabschnitt aufweist, wobei der Kontaktabschnitt in einem Überdeckungsbereich unmittelbar auf dem Anschlussabschnitt aufliegend angeordnet wird,
- Verschweißen des Kontaktabschnitts mit dem Anschlussabschnitt.

Bei diesem Verfahren wird zunächst das elektrische Bauelement auf die Leiterplatte bestückt. Erst im Anschluss wird der Adapter montiert. Beim Schweißen mit dem Laser wird auch hier erreicht, dass der metallische Steg im Bereich des Kontaktabschnittes aufschmilzt und die Schmelzzone bis in den Anschlussabschnitt des Anschlusselements eindringt. Eine Beschädigung der Kontaktfläche oder des Materials der Leiterplatte wird auch hier vermieden.

Vorteilhaft kann vor dem Schritt des Anordnens des wenigstens einen Adapters das wenigstens eine Anschlusselement mit der Kontaktfläche mittels des elektrisch leitenden Werkstoffs stoffschlüssig verbunden werden.

Wird als elektrisch leitender Werkstoff ein Lot eingesetzt, kann während des Schrittes des Verschweißens des Kontaktabschnitts mit dem Anschlussabschnitt vorteilhaft gleichzeitig das Anschlusselement mit der Kontaktfläche durch den Wärmeeintrag des Schweißvorgangs verlötet werden. Gegebenenfalls kann der Laser nach der für den Schweißvorgang notwendigen Zeit noch kurzzeitig mit niedriger Leistung Wärme in die Verbindungstelle einkoppeln, um ein sicheres Aufschmelzen des Lotes zu erreichen.

### Kurze Beschreibung der Zeichnungen

Ausführungsbeispiele der Erfindung sind in der Zeichnung dargestellt und werden in der nachfolgenden Beschreibung näher erläutert. Es zeigen
Fig. 1 einen Querschnitt durch ein erfindungsgemäßes elektronisches Steuermodul, das mittels einer Zwischenplatte auf eine Getriebehydraulikplatte montiert ist,
Fig. 2 ein Querschnitt durch ein erfindungsgemäßes elektronisches Steuermodul, das direkt auf eine Getriebehydraulikplatte montiert ist,
Fig. 3. eine Detailansicht aus Fig. 1, welche die Kontaktierung zwischen Anschlusselement, metallischem Steg und Kontaktfläche in einer vergrößerten Darstellung zeigt,
Fig. 4 eine alternative Ausführungsform zur Fig. 3,
Fig. 5a, 5b und 5c jeweils Seitenansichten eines beispielshaft dargestellten Adapters mit Haltekörper und metallischem Steg,
Fig. 6 eine Seitenansicht eines weiteren Ausführungsbeispiels für den Adapter,
Fig. 7a bis 7c einen Seitenansicht jeweils eines Adapter mit einer Kennzeichnung von Positionen, die zur Herstellung der Schweißverbindung und für den Lötvorgang vorgesehen sind.

### Ausführungsformen der Erfindung

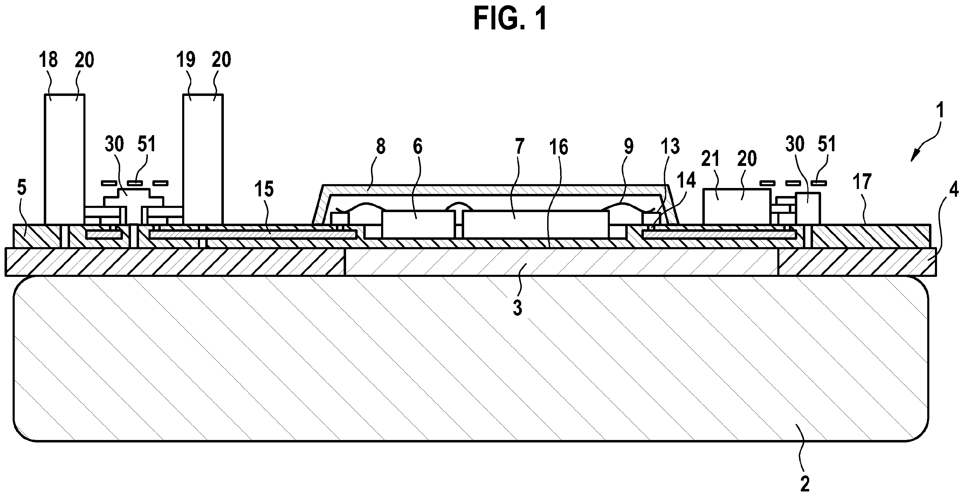

Fig. 1 zeigt einen Querschnitt durch ein elektronisches Steuermodul 1 für ein Kraftfahrzeuggetriebe. Das elektronische Steuermodul 1 weist eine Leiterplatte 5 als Träger der Aufbau- und Verbindungstechnik auf. Bei der Leiterplatte handelt es sich um eine starre Leiterplatte, beispielsweise um eine Leiterplatte in FR4-Ausführung oder höherwertig, also beispielsweise um eine Leiterplatte aus glasfaserverstärktem Epoxydharz. Die Leiterplatte weist im Inneren wenigstens eine oder mehrere parallele, mit Leiterbahnen 15 versehene Lagen auf. Die Verbindung der Leiterbahnen unterschiedlicher Lagen erfolgt über Zwischenverbindungen (VIA), die auch als Durchkontaktierungen bezeichnet werden. Die Leiterplatte 5 weist eine Bestückungsseite 17 und eine davon abgewandte Unterseite 16 auf. Die Leiterbahnen 15 sind ebenfalls über Zwischenverbindungen 14 mit Kontaktflächen 13 auf der Bestückungsseite 17 der Leiterplatte 5 elektrisch verbunden. Die Bestückungsseite 17 der Leiterplatte 5 ist zur Bestückung mit Bauelementen bestimmt, während die davon abgewandte Unterseite 16 nicht mit Bauelementen bestückt ist. Wie man in Fig. 1 erkennen kann, weist die Leiterplatte 5 auf der Bestückungsseite 17 in ihrem zentralen Bereich eine wannenförmige Ausnehmung auf, die beispielsweise durch Fräsen hergestellt ist und in der ein elektronisches Schaltungsteil 7 und eine Leistungselektronik 6 angeordnet sind, die beispielsweise auf den Grund der wannenförmigen Ausnehmung aufgeklebt sind und über Bonddrähte 9 untereinander und mit den Kontaktflächen 13 elektrisch verbunden sind. Natürlich können die Bauelemente 6, 7 auch ohne die wannenförmige Ausnehmung direkt auf die Leiterplatte 5 aufgebracht sein. Im Bereich der wärmeerzeugenden Bauelemente des elektronischen Schaltungsteils 7 oder der Leistungselektronik 6 können weiterhin noch thermische VIAs in der Leiterplatte 5 angeordnet sein, die lediglich eine Wärmeableitung auf die Unterseite 16 der Leiterplatte 5 ermöglichen und keine elektrische Funktion haben.

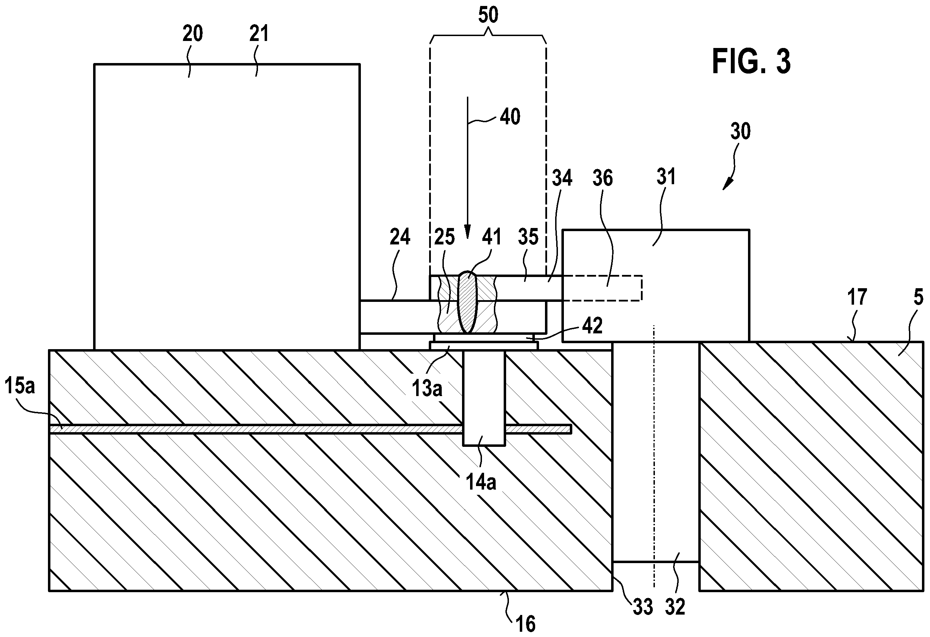

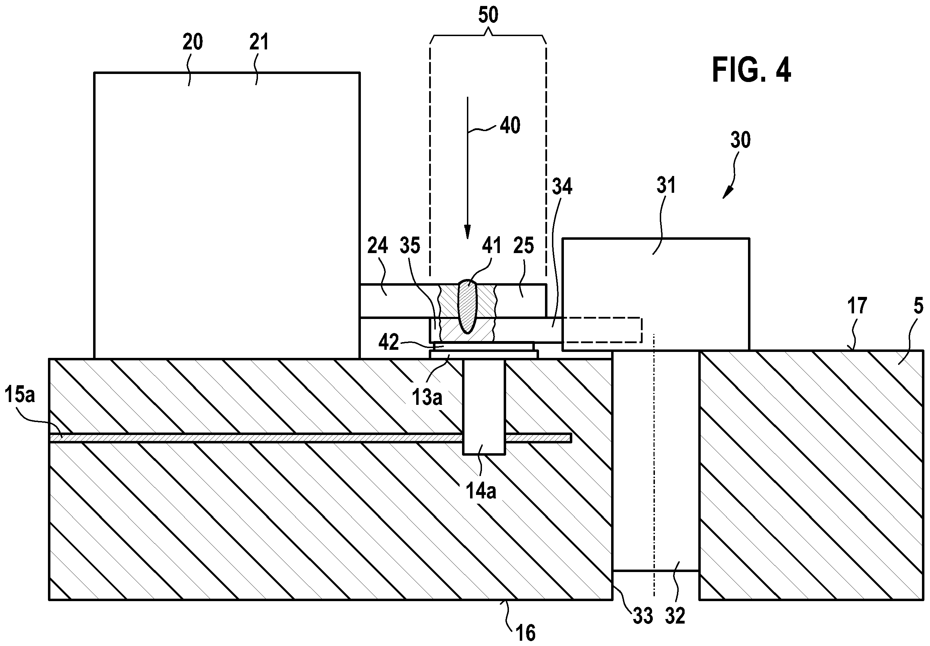

Der mit dem elektronischen Schaltungsteil 7 und der Leistungselektronik 6 versehene wannenförmige Bereich auf der Bestückungsseite 17 der Leiterplatte 5 ist mit einem Deckel 8 dicht abgedeckt. Der Deckel 8 verhindert das Eindringen von Getriebefluid in den Gehäuseraum unter dem Deckel, so dass die dort angeordneten Bauelemente gegenüber dem Außenraum gekapselt sind. Zusätzlich kann der Gehäuseraum unter dem Deckel 8 zum Schutz der dort angeordneten Bauelemente beispielsweise mit einem Gel gefüllt sein. Die elektrische Verbindung der elektronischen Bauelemente unter dem Deckel 8 mit außerhalb des Deckels angeordneten Bauelementen erfolgt über die Leiterbahnen 15. In Fig. 1 sind die außerhalb des Deckels 8 angeordneten elektrischen Bauelemente 20 dargestellt. Dabei kann es sich beispielsweise um einen Stecker 18, einen Aktuator 19 oder ein Sensorbauelement 21 handeln. Außerdem sind auf der Bestückungsseite 17 Adapter 30 vorgesehen, die beispielsweise mit Befestigungszapfen in Einführungsöffnungen der Leiterplatte 5 befestigt sind. Jedem elektrischen Bauelement 20 außerhalb des Deckels 8 ist wenigstens ein Adapter 30 zugeordnet. Dies wird anhand der Figuren 3 und 4 noch näher erläutert werden. Die Unterseite 16 der Leiterplatte 5 in Fig. 1 ist auf eine Kunststoff-Trägerplatte 4 montiert. Die Kunststoff-Trägerplatte 4 weist unterhalb des elektronischen Schaltungsteils 7 und der Leistungselektronik 6 eine Metalleinlage 3 auf, über die von den thermischen VIAs abgeleitete Wärme an eine Hydraulikplatte 2 des Getriebes abgeleitet wird.

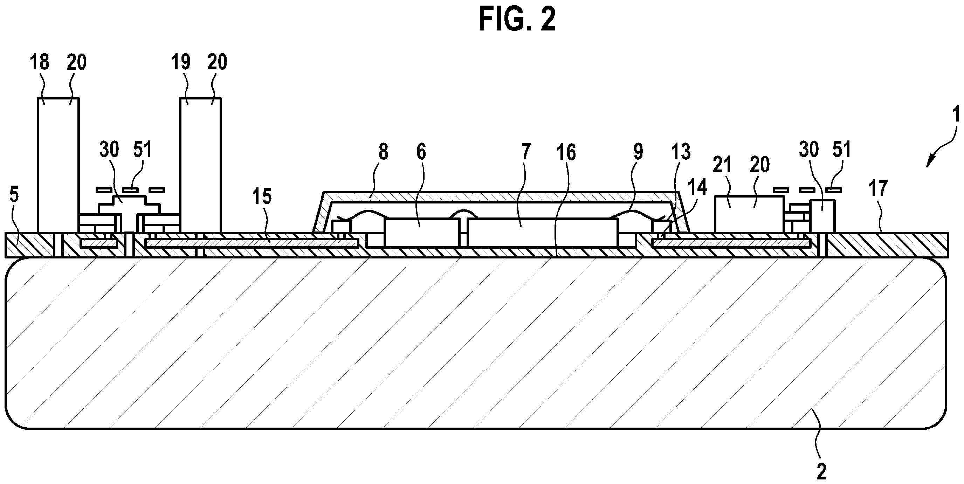

Fig. 2 offenbart eine weitere Ausführungsform, bei der das Steuermodul 1 ohne Zwischenlage einer Kunststoff-Trägerplatte 4 direkt auf die Hydraulikplatte 2 des Getriebes aufgebracht ist. In beiden Ausführungsbeispielen von Fig. 1 und Fig. 2 sind an der Unterseite 16 der Leiterplatte 5 keine elektrisch leitenden Teile vorgesehen, so dass an dieser Seite keine Maßnahmen zur Isolierung von elektrisch leitenden Teilen getroffen werden müssen, insbesondere müssen keine Spanschutzdeckel auf der Unterseite 16 angeordnet werden, da keine elektrischen Anschlussstifte bis zur Unterseite 16 durchragen. Daher ist auch keine weitere Abdeckplatte auf der Unterseite 16 der Leiterplatte 5 zur Erzielung einer ebenen Anbindungsfläche nötig, das die ebene Unterseite 16, an der sich keine elektrisch leitenden Teile befinden, direkt auf die Getriebehydraulikplatte 2 aufgebracht werden kann.

Fig. 3. zeigt eine Detailansicht aus Fig. 1 im Bereich des elektrischen Anschlusses des elektrischen Bauelementes 20, bei dem es sich beispielsweise um ein Sensorbauelement handelt 21. Wie man in Fig. 3 erkennt ist eine innere Leiterbahn 15a der Leiterplatte 5 mit einer Kontaktfläche 13a auf der Bestückungsseite 17 der Leiterplatte 5 über einen Zwischenverbinder 14a elektrisch verbunden. Auf der Kontaktfläche 13a befindet sich ein elektrisch leitender Werkstoff 42. Dabei kann es sich beispielsweise um einen aushärtbaren Kleber oder ein Lot handeln. Im hier gezeigten Ausführungsbeispiel ist der Werkstoff 42 ein Lot. Das elektrische Bauelement 20 ist als oberflächenmontiertes Bauelement (SMD, surface mounted device) direkt auf die Bestückungsseite 17 aufgesetzt. Das elektrische Bauelement weist Anschlusselemente 24 mit vorzugsweise rechteckförmigem Querschnitt auf. In Fig. 3 ist nur ein Anschlusselement 24 erkennbar. Die Anschlusselemente 24 verlaufen parallel zur Bestückungsseite 17. Wichtig ist, dass die Anschlusselemente 24 in der Endstellung auf der Leiterplatte 5 einen parallel zur Bestückungsseite 17 verlaufenden Anschlussabschnitt 25 aufweisen. Zwischen dem Anschlussabschnitt 25 und dem elektrischen Bauelement 20 können die Anschlusselemente anders als in Fig. 3 gezeigt auch Biegungen oder Abknickungen aufweisen. Der Anschlussabschnitt 25 ist beim dem in Fig. 3 gezeigten Ausführungsbeispiel direkt über dem Werkstoff 42, also dem Lot angeordnet und über das Lot stoffschlüssig und elektrisch leitend mit der Kontaktfläche 13a verbunden.

Weiterhin ist in Fig. 3 ein Adapter 30 dargestellt. Der Adapter 30 weist einen Haltekörper 31 mit beispielsweise quaderförmiger Geometrie auf, der an der Leiterplatte 5 befestigt ist. Dies kann in unterschiedlicher Weise ausgeführt sein. Es ist beispielsweise möglich, den Haltekörper 31 an der Leiterplatte 5 durch formschlüssige, kraftschlüssige oder stoffschlüssige Befestigungsmittel festzulegen. Wichtig ist, dass der Halterkörper 31 so befestigt ist, dass er mechanische Spannungen aufnehmen kann. Der in der Fig. 3 dargestellte bevorzugte Adapter 31 weist daher einen Haltekörper 31 auf, der mit einem oder mehreren Befestigungszapfen 32 ausgebildet ist. Der Befestigungszapfen 32 steht an der Unterseite des Halterköpers 31 senkrecht von diesem ab. Der Befestigungszapfen 32 kann zusammen mit dem Halterköper 31 durch Spritzguss hergestellt werden. Dabei wird wenigstens ein metalischer Steg 34 in den Halterköper 31 teilweise eingespritzt. Der metallische Steg 31 ist beispielswiese als Metallstreifen mit rechteckförmigem Querschnitt ausgebildet und besteht vorzugsweise aus dem gleichen Material wie die Anschlusselemente 24 des Bauelementes 2. Beispielsweise können beide aus Kupfer bestehen. Unabhängig von der Materialauswahl des metallischen Steges 34 ist es vorteilhaft aber nicht notwendig, dass der metallische Steg 34 ein ähnliches thermisches Ausdehnungsverhalten wie das Anschlusselement 24 aufweist. Wie in Fig. 3 zu erkennen ist, weist der metallische Steg 35 einen Endabschnitt 36 auf der vollständig in den Haltekörper 31 eingebettet ist und einen Kontaktabschnitt 35, der seitlich von dem Haltekörper 31 absteht. Zwischen dem Kontaktabschnitt 35 und dem Haltekörper 31 kann der metallische Steg Biegungen oder Abwinklungen aufweisen. In dem hier dargestellten Ausführungsbeispiel ist der metallische Steg als Blechteil durch Stanzen hergestellt und im Wesentlichen eben ausgebildet. Der Kontaktabschnitt 35 des metallischen Steges 34 liegt flach auf dem Anschlussabschnitt 24 auf. Der Kontaktabschnitt 35 und der Anschlussabschnitt 25 verlaufen parallel zur Leiterplatte 5 und der Kontaktabschnitt 35 ist in einem Überdeckungsbereich 50 direkt über dem Anschlussabschnitt 25 angeordnet, so dass er in dem Überdeckungsbereich 50 flach auf dem Anschlussabschnitt 25 aufliegt. In dem Überdeckungsbereich 50 ist der Kontaktabschnitt 35 mit dem Anschlussabschnitt 25 verschweißt. Die durch Verlöten oder Leitkleber hergestellte elektrische Verbindung zwischen dem Anschlusselement 24 und der Kontaktfläche 13a wird durch den Adapter stabilisiert und entlastet. Wie in Fig. 1 und Fig. 2 schematisch dargestellt ist, kann zum Schluss im Bereich der Schweißstelle 41 eine Schutzabdeckung 51 aufgebracht werden. Diese deckt vorzugsweise den gesamten Kontaktabschnitt 35 und den Anschlussabschnitt 25 vollständig ab und schützt gegen Kurzschlüsse durch Metallspäne. Die Schutzabdeckung 51 kann beispielsweise durch einen Schutzlack, Vergussmasse oder ähnliches hergestellt sein.

Bei der Herstellung des in Fig. 3 beschriebenen Aufbaus wird zunächst eine Leiterplatte 5, die bereits mit dem Schaltungsteil 7, dem Leistungsteil 6 und dem Deckel 8 versehen sein kann und die auf der Bestückungsseite 17 außerhalb des von dem Deckel 8 abgedeckten Bereichs Kontaktflächen 13a aufweist, die mit einem leitenden Werkstoff 42 versehen sind, insbesondere mit einem Lotmaterialauftrag, mit dem wenigstens einen elektrischen Bauelement 20 bestückt. Dabei wird vorzugsweise der Anschlussabschnitt 25 des Anschlusselementes 24 unmittelbar über der mit dem elektrisch leitenden Werkstoff 42 versehenen Kontaktfläche 13a angeordnet. Danach kann der Anschlussabschnitt 25 mit der Kontaktfläche 13a verlötet werden. Dies kann aber auch noch später nach der Aufbrinung eines oder mehrere Adapter 30 geschehen. Schließlich wird die Leiterplatte 5 mit den Adaptern 30 bestückt, wobei ein Adapter 30 beispielswiese mit dem Befestigungszapfen 32 in die Einführöffnung 33 so lange eingepresst wird, bis der Kontaktabschnitt 35 des metallischen Steges 34 in dem Überdeckungsbereich 50 auf der von der Kontaktfläche 13a abgewandten Seite des Anschlussabschnitts 25 flach auf diesem aufliegt. Der Anschlussabschnitt 25 und der Kontaktabschnitt 35 verlaufen im Überdeckungsbereich im Wesentlichen parallel zur Bestückungsseite 17 der Leiterplatte 5. Danach wird mittels eines Lasers in Richtung des Pfeils 40 in Fig. 3 eine Schweißverbindung 41 hergestellt. Der Laser ist dabei senkrecht zur Leiterplatte 5 auf den Überdeckungsbereich 50 gerichtet und schmilzt den Kontaktabschnitt 35 und den darunter liegenden Anschlussabschnitt 25 partiell soweit auf, dass eine Schweißverbindung 41 entsteht. Aufgrund des großen Überdeckungsbereichs 50 wird der Schweißvorgang kaum durch Lagetoleranzen der Bauelemente beeinträchtigt. Geschweißt wird beispielsweise mit grünem Laserlicht. Solche Laser werden vorteilhaft für sprizerfreies und energiearmes Schweißen von dünnen Kupferwerkstoffen verwandt. Der Schweißvorgang kann so durchgeführt werden, dass der Wärmeeintrag beim Schweißen auch die Lotschicht unter dem Anschlussabschnitt 25 aufschmilzt, so dass gleichzeitig der Anschlussabschnitt 25 mit der Kontaktfläche 13a verlötet wird. Hierzu ist es vorteilhaft, wenn die Kontaktfläche 13a direkt unterhalb des Überdeckungsbereich 50 beziehungswiese innerhalb der Projektion des Überdeckungsbereichs 50 in Richtung 40 angeordnet ist, denn dann erreicht die Wärme direkt das Lotdepot auf der Kontaktfläche 13a.

Die Herstellung der elektrischen Verbindungen wird vorteilhaft in nur einem Arbeitsschritt erreicht, der in einer automatisierten Fertigungsanlage mit großer Geschwindigkeit durchgeführt werden kann. Optional wird zuvor noch ein gut beherrschter Lötvorgang oder Aushärtevorgang eines Klebers zur stoffschlüssigen Verbindung des Anschlusselementes 24 mit der Kontaktfläche 13a durchgeführt. Dies kann beispielsweise im Dampfphasenlöten für alle Lötstellen gleichzeitig erfolgen.

Ein alternatives Herstellungsverfahren soll anhand der Fig. 4 erläutert werden. Bei diesem Verfahren wird zunächst eine Leiterplatte 5, die bereits mit dem Schaltungsteil 7, dem Leistungsteil 6 und dem Deckel 8 versehen sein kann und die auf der Bestückungsseite 17 außerhalb des von dem Deckel 8 abgedeckten Bereichs Kontaktflächen 13a aufweist, die mit einem leitenden Werkstoff 42 versehen sind, insbesondere mit einem Lotmaterialauftrag, im Unterschied zu dem Ausführungsbeispiel der Fig. 3 zuerst mit dem Adapter 30 bestückt. Der Befestigungszapfen 32 wird dabei so lange in die Einführungsöffnung 33 eingepresst, bis der Kontaktabschnitt 35 parallel zur Bestückungsseite 17 auf dem Werkstoff 42 aufliegt. Anschließend kann der Kontaktabschnitt 35 mit der Kontaktfläche 13a stoffschlüssig verbunden werden, was beispielsweise durch Löten, insbesondere Dampfphasenlöten erfolgen kann, wenn der Werkstoff 42 ein Lot ist. Dies kann aber auch noch später erfolgen. Danach wird wenigstens ein elektrisches Bauelement 20 auf der mit dem wenigstens einen Adapter 30 versehenen Leiterplatte 5 angeordnet, wobei das wenigstens eine elektrische Bauelement 20 wenigstens ein elektrisches Anschlusselement 24 aufweist, das einen parallel zur Bestückungsseite 17 der Leiterplatte 5 verlaufenden Anschlussabschnitt 25 aufweist. Der Anschlussabschnitt 25 wird in einem Überdeckungsbereich 50 unmittelbar auf dem Kontaktabschnitt 35 aufliegend angeordnet. Danach wird mittels eines Lasers in Richtung des Pfeils 40 in Fig. 4 eine Schweißverbindung 41 hergestellt. Der Laser ist dabei senkrecht zur Leiterplatte 5 auf den Überdeckungsbereich 50 gerichtet und schmilzt den Anschlussabschnitt 25 und den darunter liegenden Kontaktabschnitt 35 partiell soweit auf, dass eine Schweißverbindung 41 entsteht. Der Schweißvorgang kann so durchgeführt werden, dass der Wärmeeintrag beim Schweißen auch die Lotschicht unter dem Kontaktabschnitt 35 aufschmilzt, so dass gleichzeitig der Kontaktabschnitt 35 mit der Kontaktfläche 13a verlötet wird.

Natürlich versteht sich, dass die anhand der Figuren 3 und 4 beschriebenen Herstellungsverfahren auch kombiniert werden können.

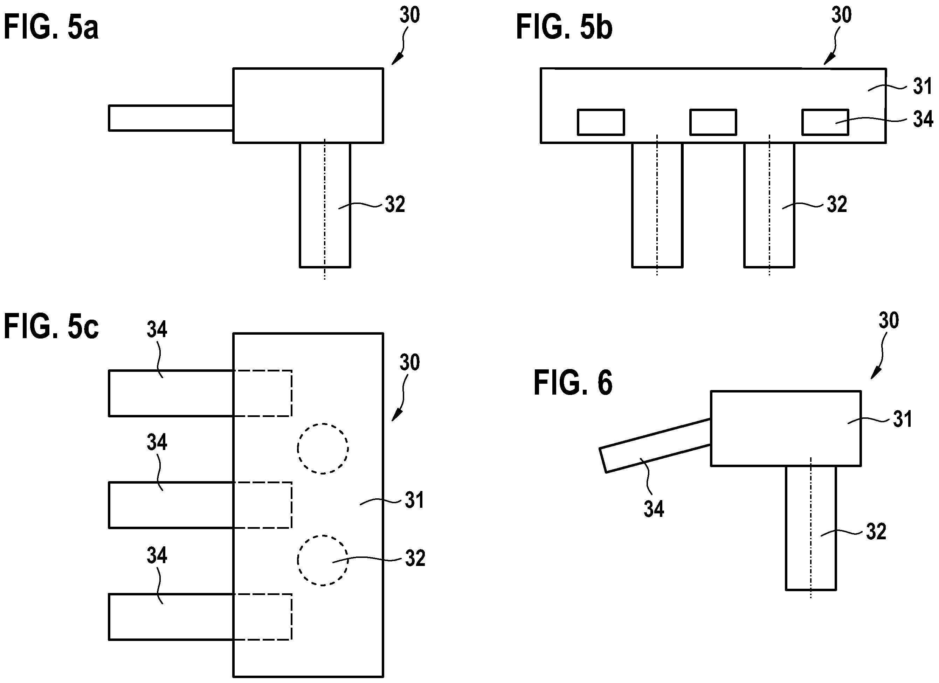

Die Figuren 5a bis 5c zeigen verschiedene Seitenansichten eines Ausführungsbeispiels des Adapters 30. Wie in Fig. 5c zu erkennen ist, kann der Adapter 30 beispielsweise auch zwei oder mehr Befestigungszapfen 32 aufweisen. An dem Haltekörper 31 eines Adapters 30 können außerdem mehrere metallische Stege 34 festgelegt sein. Im Beispiel der Fig. 5b sind es drei metallische Stege 34, die zur Kontaktierung von drei Anschlusselementen 24 eines Bauelementes 20 dienen.

In Fig. 6 ist dargestellt, dass ein metallischer Steg 34 an dem Haltekörper 31 auch schräg gestellt sein kann, so dass er in der Ausgangslage nicht genau senkrecht zum Befestigungszapfen 32 ausgerichtet ist. Erst beim Einpressen des Adapters 30 in die Leiterplatte wird der metallische Steg gegen die Kontaktfläche 13a oder den Anschlussabschnitt 25 eine Bauelements angedrückt und dabei elastisch zurückgebogen, so dass sich der Kontaktabschnitt 35 parallel zur Bestückungsseite 17 der Leiterplatte 5 ausrichtet. Vorteilhaft entsteht dabei eine Vorspannkraft, die in Richtung auf die Kontaktfläche 13a (Fig. 4) oder in Richtung auf den Anschlussabschnitt 25 (Fig. 3) wirkt. Dadurch kann vorteilhaft sichergestellt werden, dass beim Aufschmelzen von Lot auf der Kontaktfläche 13a, der Kontaktabschnitt 35 beziehungsweise der Anschlussabschnitt 25, je nachdem, was mit der Kontaktfläche 13a verlötet werden soll, nicht versehentlich aus dem aufgeschmolzenen Lot abhebt.

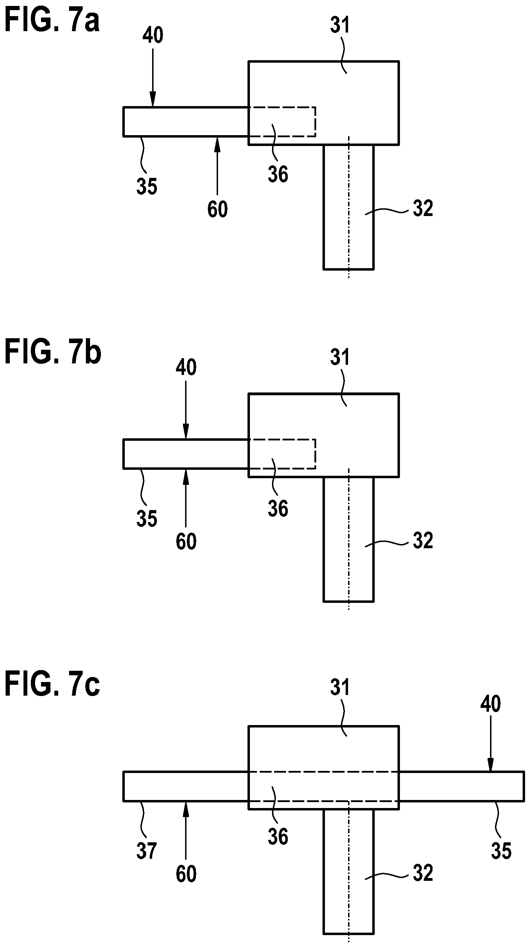

Die Figuren 7a und 7c zeigen weitere Ausführungsbeispiele, dabei entspricht die Darstellung der Fig. 7b dem Aufbau nach Fig. 3 oder Fig. 4, bei dem die Verschweißung in Richtung des Pfeils 40 direkt oberhalb der für die Herstellung einer stoffschlüssigen Verbindung zwischen dem metallischen Steg 34 und der Kontaktfläche 13a beziehungsweise zwischen dem Anschlusselement 24 und der Kontaktfläche 13a vorgesehen Position 60 erfolgt.

In Fig. 7a ist dargestellt, dass die Verschweißung in Richtung des Pfeils 40 auch seitlich versetzt zu der Lötstelle 60 angeordnet sein kann. Das heißt, dass sich in diesem Ausführungsbeispiel die stoffschlüssige elektrische Verbindungsstelle des metallischen Steges 34 mit der Kontaktfläche 13a der Leiterplatte 5 in Richtung des Pfeils 40 gesehen nicht unterhalb des Überdeckungsbereichs von Kontaktabschnitt 35 und Anschlussabschnitt 25 befinden muss.

Bei dem Ausführungsbeispiel der Fig. 7c ist der metallische Steg beidseitig aus dem Haltekörper 31 herausgeführt. Die gestrichelte Linie markiert den zentralen in den Haltekörper 31 eingebetteten Abschnitt 36 des metallischen Steges 35. An einer dem Kontaktabschnitt 35, der für die Herstellung der Schweißverbindung vorgesehen ist, gegenüberliegenden Seite des Haltekörpers 31 steht ein weitere Abschnitt 37 von dem Haltekörper 31 ab, der zur Herstellung einer stoffschlüssigen Verbindung zu einer Kontaktfläche 13a vorgesehen ist. Der Abschnitt 37 kann natürlich auch einer anderen Stelle, beispielsweise rechtwinklig zu dem Kontaktabschnitt 35, aber immer noch parallel zur Bestückungsseite 17 von dem Haltekörper 31 abstehen.

## Patentansprüche

1. Elektronisches Steuermodul (1), insbesondere für eine Getriebesteuerung, umfassend eine Leiterplatte (5) mit einer Bestückungsseite (17), auf der wenigstens eine Kontaktfläche (13a) angeordnet ist, und wenigstens ein elektrisches Bauteil (20) mit wenigstens einem elektrischen Anschlusselement (24), das einen parallel zur Bestückungsseite (17) der Leiterplatte (5) verlaufenden Anschlussabschnitt (25) aufweist, der mit der wenigstens einen Kontaktfläche (13a) elektrisch verbunden ist, wobei an der Leiterplatte (5) wenigstens ein Adapter (30) angeordnet ist, der unabhängig von dem wenigstens einen elektrischen Bauelement (20), als separates Teil auf der Leiterplatte (5) angeordnet ist und der einen außerhalb der wenigstens einen Kontaktfläche (13a) an der Leiterplatte (5) befestigten Haltekörper (31) und wenigstens einen an dem Haltekörper (31) angeordneten metallischen Steg (34) mit einem parallelen zur Bestückungsseite der Leiterplatte verlaufenden Kontaktabschnitt (35) aufweist, wobei der Kontaktabschnitt (35) des wenigstens einen metallischen Stegs (34) und der Anschlussabschnitt (25) des wenigstens einen Anschlusselementes (24) in einer Richtung senkrecht zur Leiterplatte gesehen in einem Überdeckungsbereich (50) aufeinander liegend angeordnet sind und in dem Überdeckungsbereich (50) miteinander verschweißt sind, und dass der wenigstens eine metallische Steg (34) oder das wenigstens eine Anschlusselement (24) mittels eines auf die wenigstens eine Kontaktfläche (13a) aufgebrachten elektrisch leitenden Werkstoffs (42) mit der wenigstens einen Kontaktfläche (13a) elektrisch kontaktiert sind, **dadurch gekennzeichnet, dass**
- sich der Anschlussabschnitt (25) des wenigstens einen Anschlusselementes (24) in direktem Kontakt mit dem elektrisch leitenden Werkstoff (42) auf der wenigstens einen Kontaktfläche (13a) der Leiterplatte (5) befindet und dass der Kontaktabschnitt (35) des wenigstens einen metallischen Steges (34) auf der von der wenigstens einen Kontaktfläche (13a) abgewandten Seite des Anschlussabschnitts (25) auf diesem aufliegt oder
- dass sich der Kontaktabschnitt (35) des wenigstens einen metallischen Steges (34) in direktem Kontakt mit dem elektrisch leitenden Werkstoff (42) auf der wenigstens einen Kontaktfläche (13a) der Leiterplatte (5) befindet und dass der Anschlussabschnitt (25) des wenigstens einen Anschlusselementes (24) auf der von der wenigstens einen Kontaktfläche (13a) abgewandten Seite des Kontaktabschnitts (35) auf diesem aufliegt.

2. Elektronisches Steuermodul nach Anspruch 1, **dadurch gekennzeichnet, dass** der Haltekörper (31) wenigstens einen in eine Einführungsöffnung (33) der Leiterplatte (5) eingeführten, insbesondere eingepressten Befestigungszapfen (32) aufweist.

3. Elektronisches Steuermodul nach Anspruch 1 oder 2, **dadurch gekennzeichnet, dass** der Haltekörper (31) aus Kunststoff gefertigt ist.

4. Elektronisches Steuermodul nach einem der Ansprüche 1 bis 3, **dadurch gekennzeichnet, dass** der wenigstens eine metallische Steg (34) zumindest an einer Seite des Halterkörpers, parallel zur Leiterplatte (15) aus dem Haltekörper (31) seitlich herausragt.

5. Elektronisches Steuermodul nach Anspruch 1, **dadurch gekennzeichnet, dass** die wenigstens eine Kontaktfläche (13a) der Leiterplatte (5) in einer Richtung senkrecht zur Leiterplatte gesehen, unterhalb des Überdeckungsbereichs (50) von Kontaktabschnitt (35) und Anschlussabschnitt (25) angeordnet ist.

6. Elektronisches Steuermodul nach Anspruch 1, **dadurch gekennzeichnet, dass** der Kontaktabschnitt (35) des wenigstens einen Steges (34) und der Anschlussabschnitt (25) des wenigstens einen Anschlusselementes (24) durch Metallstreifen mit rechteckförmigen Querschnitt gebildet werden, die zumindest im Überdeckungsbereich (50) flach aufeinander liegend angeordnet sind.

7. Verfahren zur Herstellung eines elektronischen Steuermoduls, insbesondere eines Steuermoduls für eine Getriebesteuerung mit folgenden Schritten:
- Bereitstellen einer Leiterplatte (5) mit einer Bestückungsseite (17), auf der wenigstens eine Kontaktfläche (13a) angeordnet ist,
- Aufbringen eines elektrisch leitenden Werkstoffs (42) auf die wenigstens eine Kontaktfläche (13a),
- Anordnen wenigstens eines Adapters (30) auf der Leiterplatte (5), wobei der wenigstens eine Adapter (30) einen Haltekörper (31) zur Befestigung an der Leiterplatte (5) außerhalb der wenigstens einen Kontaktfläche (13a) und wenigstens einen an dem Haltekörper (31) angeordneten metallischen Steg (34) mit einem zumindest in der auf der Leiterplatte befestigten Endstellung des Adapters (30) parallel zur Bestückungsseite (17) der Leiterplatte (5) verlaufenden Kontaktabschnitt (35) aufweist, wobei der wenigstens eine metallische Steg (34) unmittelbar über der wenigstens einen mit dem elektrisch leitenden Werkstoff (42) versehenen Kontaktfläche (13a) angeordnet wird,
- Anordnen wenigstens eines elektrischen Bauteils (20) auf der mit dem wenigstens einen Adapter (30) versehenen Leiterplatte (5), wobei das wenigstens eine elektrische Bauteil (20) wenigstens ein elektrisches Anschlusselement (24) aufweist, das einen parallel zur Bestückungsseite (17) der Leiterplatte (5) verlaufenden Anschlussabschnitt (25) aufweist, wobei der Anschlussabschnitt (25) in einem Überdeckungsbereich (50) unmittelbar auf dem Kontaktabschnitt (35) aufliegend angeordnet wird,
- Verschweißen des Anschlussabschnitts (25) mit dem Kontaktabschnitt (35) wobei der elektrisch leitende Werkstoff (42) ein Lot ist und während des Schrittes des Verschweißens des Anschlussabschnitts (25) mit dem Kontaktabschnitt (35) gleichzeitig der Kontaktabschnitt (25) mit der Kontaktfläche (13a) durch den Wärmeeintrag des Schweißvorgangs verlötet wird.

8. Verfahren zur Herstellung eines elektronischen Steuermoduls, insbesondere eines Steuermoduls für eine Getriebesteuerung mit folgenden Schritten:
- Bereitstellen einer Leiterplatte (5) mit einer Bestückungsseite (17), auf der wenigstens eine Kontaktfläche (13a) angeordnet ist,
- Aufbringen eines elektrisch leitenden Werkstoffs (42) auf die wenigstens seine Kontaktfläche (13a),
- Anordnen wenigstens eines elektrischen Bauteils (20) auf der Leiterplatte (5), wobei das wenigstens eine elektrische Bauteil (20) wenigstens ein elektrisches Anschlusselement (24) aufweist, das einen parallel zur Bestückungsseite (17) der Leiterplatte (5) verlaufenden Anschlussabschnitt (25) aufweist, wobei das wenigsten eine Anschlusselement (24) unmittelbar über der mit dem elektrisch leitenden Werkstoff (42) versehenen Kontaktfläche (13a) angeordnet wird,
- Anordnen wenigstens eines Adapters (30) auf der mit dem wenigstens einen elektrischen Bauteil (20) versehen Leiterplatte (5), wobei der wenigstens eine Adapter (30) einen Haltekörper (31) zur Befestigung an der Leiterplatte (5) außerhalb der wenigstens einen Kontaktfläche (13a) und wenigstens einen an dem Haltekörper (31) angeordneten metallischen Steg (34) mit einem zumindest in der auf der Leiterplatte befestigten Endstellung des Adapters (30) parallel zur Bestückungsseite (17) der Leiterplatte (5) verlaufenden Kontaktabschnitt (35) aufweist, wobei der Kontaktabschnitt (35) in einem Überdeckungsbereich (50) unmittelbar auf dem Anschlussabschnitt (25) aufliegend angeordnet wird,
- Verschweißen des Kontaktabschnitts (35) mit dem Anschlussabschnitt (25).

9. Verfahren nach Anspruch 8, **dadurch gekennzeichnet, dass** vor dem Schritt des Anordnens des wenigstens einen Adapters (30) das wenigsten eine Anschlusselement (24) mit der Kontaktfläche (13a) mittels des elektrisch leitenden Werkstoffs (42) stoffschlüssig verbunden wird.

10. Verfahren nach Anspruch 8, **dadurch gekennzeichnet, dass** der elektrisch leitende Werkstoff (42) ein Lot ist und dass während des Schrittes des Verschweißens des Kontaktabschnitts (35) mit dem Anschlussabschnitt (25) gleichzeitig das wenigstens eine Anschlusselement (24) mit der Kontaktfläche (13a) durch den Wärmeeintrag des Schweißvorgangs verlötet wird.

## Claims

1. Electronic control module (1), in particular for a transmission controller, comprising a printed circuit board (5) with a component side (17), on which at least one contact area (13a) is arranged, and at least one electrical component (20) with at least one electrical connection element (24) which has a connection section (25) which runs parallel to the component side (17) of the printed circuit board (5) and is electrically connected to the at least one contact area (13a), wherein at least one adapter (30) is arranged on the printed circuit board (5), which adapter (30) is arranged, independently of the at least one electrical component (20), as a separate part on the printed circuit board (5), and has a holding body (31) which is attached to the printed circuit board (5) outside the at least one contact area (13a), and at least one metallic web (34) which is arranged on the holding body (31) and has a contact section (35) running parallel to the component side of the printed circuit board, wherein the contact section (35) of the at least one metallic web (34) and the connection section (25) of the at least one connection element (24) are arranged, when viewed in a direction perpendicular to the printed circuit board, resting one on the other in an overlapping region (50) and are welded to one another in the overlapping region (50), and in that the at least one metallic web (34) or the at least one connection element (24) are placed in electrical contact with the at least one contact area (13a) by means of an electrically conductive material (42) applied to the at least one contact area (13a) **characterized in that**
- the connection section (25) of the at least one connection element (24) is in direct contact with the electrically conductive material (42) on the at least one contact area (13a) of the printed circuit board (5), and **in that** the contact section (35) of the at least one metallic web (34) rests on the connection section (25), on the side of said connection section (25) which faces away from the at least one contact area (13a),
or
- **in that** the contact section (35) of the at least one metallic web (34) is in direct contact with the electrically conductive material (42) on the at least one contact area (13a) of the printed circuit board (5), and **in that** the connection section (25) of the at least one connection element (24) rests on the contact section (35), on the side of said contact section (35) which faces away from the at least one contact area (13a).

2. Electronic control module according to Claim 1, **characterized in that** the holding body (31) has at least one attachment pin (32) which is inserted, in particular pressed, into an insertion opening (33) in the printed circuit board (5).

3. Electronic control module according to Claim 1 or 2, **characterized in that** the holding body (31) is fabricated from plastic.

4. Electronic control module according to one of Claims 1 to 3, **characterized in that** the at least one metallic web (34) projects laterally from the holding body (31), parallel to the printed circuit board (15), at least on one side of the holding body.

5. Electronic control module according to Claim 1, **characterized in that** the at least one contact area (13a) of the printed circuit board (5) is arranged, when viewed in a direction perpendicular to the printed circuit board, underneath the overlapping region (50) of the contact section (35) and connection section (25).

6. Electronic control module according to Claim 1, **characterized in that** the contact section (35) of the at least one web (34) and the connection section (25) of the at least one connection element (24) are formed by metal strips which have a rectangular cross section and are arranged resting flat one on top of the other at least in the overlapping region (50) .

7. Method for producing an electronic control module, in particular a control module for a transmission controller, having the following steps:
- making available a printed circuit board (5) with a component side (17) on which at least one contact area (13a) is arranged,
- applying an electrically conducting material (42) to the at least one contact area (13a),
- arranging at least one adapter (30) on the printed circuit board (5), wherein the at least one adapter (30) has a holding body (31) for attachment to the printed circuit board (5) outside the at least one contact area (13a), and at least one metallic web (34) which is arranged on the holding body (31) and has a contact section (35) running parallel to the component side (17) of the printed circuit board (5) at least in the end position of the adapter (30) in which it is attached to the printed circuit board, wherein the at least one metallic web (34) is arranged directly over the at least one contact area (13a) which is provided with electrically conductive material (42),
- arranging at least one electrical component (20) on the printed circuit board (5) which is provided with the at least one adapter (30), wherein the at least one electrical component (20) has at least one electrical connection element (24) which has a connection section (25) running parallel to the component side (17) of the printed circuit board (5), wherein the connection section (25) is arranged resting directly on the contact section (35) in an overlapping region (50), and
- welding the connection section (25) to the contact section (35), wherein the electrically conductive material (42) is a solder, and in that, during the step of welding the connection section (25) to the contact section (35), the contact section (25) is simultaneously soldered to the contact area (13a) by means of the input of heat from the welding process.

8. Method for producing an electronic control module, in particular a control module for a transmission controller, having the following steps:
- making available a printed circuit board (5) with a component side (17) on which at least one contact area (13a) is arranged,
- applying an electrically conductive material (42) to the at least one contact area (13a),
- arranging at least one electrical component (20) on the printed circuit board (5), wherein the at least one electrical component (20) has at least one electrical connection element (24) which has a connection section (25) running parallel to the component side (17) of the printed circuit board (5), wherein the at least one connection element (24) is arranged directly over the contact area (13a) which is provided with the electrically conductive material (42),
- arranging at least one adapter (30) on the printed circuit board (5) which is provided with the at least one electrical component (20), wherein the at least one adapter (30) has a holding body (31) for attachment to the printed circuit board (5) outside the at least one contact area (13a), and at least one metallic web (34) which is arranged on the holding body (31) and has a contact section (35) which runs parallel to the component side (17) of the printed circuit board (5), at least in the end position of the adapter (30) in which it is attached to the printed circuit board, wherein the contact section (35) is arranged resting directly on the connection section (25) in an overlapping region (50), and
- welding the contact section (35) to the connection section (25).

9. Method according to Claim 8, **characterized in that**, before the step of arranging the at least one adapter (30), the at least one connection element (24) is connected in a materially joined fashion to the contact area (13a) by means of the electrically conductive material (42).

10. Method according to Claim 8, **characterized in that** the electrically conductive material (42) is a solder, and **in that**, during the step of welding the contact section (35) to the connection section (25), the at least one connection element (24) is simultaneously soldered to the contact area (13a) by means of the input of heat by the welding process.

## Revendications

1. Module de commande électronique (1), notamment pour une commande de boîte de vitesses, comprenant un circuit imprimé (5) ayant un côté d'implantation (17) sur lequel est disposée au moins une surface de contact (13a), et au moins un composant électrique (20) pourvu d'au moins un élément de raccordement (24) électrique qui possède une portion de raccordement (25), laquelle suit un tracé parallèle au côté d'implantation (17) du circuit imprimé (5) et est reliée électriquement à l'au moins une surface de contact (13a), au moins un adaptateur (30) étant disposé sur le circuit imprimé (5), lequel est disposé indépendamment de l'au moins un composant électrique (20) en tant que pièce séparée sur le circuit imprimé (5) et possède un corps de maintien (31), fixé au circuit imprimé (5) à l'extérieur de l'au moins une surface de contact (13a) et au moins une barrette métallique (34) disposée au niveau du corps de maintien (31) avec une portion de contact (35) qui suit un tracé parallèle au côté d'implantation du circuit imprimé, la portion de contact (35) de l'au moins une barrette métallique (34) et la portion de raccordement (25) de l'au moins un élément de raccordement (24), dans une direction vue perpendiculairement au circuit imprimé, étant disposées l'une au-dessus de l'autre dans une zone de recouvrement (50) et étant soudées l'une à l'autre dans la zone de recouvrement (50), et l'au moins une barrette métallique (34) ou l'au moins un élément de raccordement (24) étant mis en contact électrique avec l'au moins une surface de contact (13a) au moyen d'un matériau électriquement conducteur (42) appliqué sur l'au moins une surface de contact (13a), **caractérisé en ce que**
- la portion de raccordement (25) de l'au moins un élément de raccordement (24) se trouve en contact direct avec le matériau électriquement conducteur (42) sur l'au moins une surface de contact (13a) du circuit imprimé (5) et **en ce que** la portion de contact (35) de l'au moins une barrette métallique (34) sur le côté de la portion de raccordement (25) à l'opposé de l'au moins une surface de contact (13a) repose sur celui-ci
ou
- **en ce que** la portion de contact (35) de l'au moins une barrette métallique (34) se trouve en contact direct avec le matériau électriquement conducteur (42) sur l'au moins une surface de contact (13a) du circuit imprimé (5) et **en ce que** la portion de raccordement (25) de l'au moins un élément de raccordement (24) sur le côté de la portion de contact (35) à l'opposé de l'au moins une surface de contact (13a) repose sur celui-ci.

2. Module de commande électronique selon la revendication 1, **caractérisé en ce que** le corps de maintien (31) possède au moins un tenon de fixation (32) introduit, notamment enfoncé, dans une ouverture d'introduction (33) du circuit imprimé (5).

3. Module de commande électronique selon la revendication 1 ou 2, **caractérisé en ce que** le corps de maintien (31) est fabriqué en matière plastique.

4. Module de commande électronique selon l'une des revendications 1 à 3, **caractérisé en ce que** l'au moins une barrette métallique (34) fait saillie latéralement hors du corps de maintien (31) sur au moins un côté du corps de maintien, parallèlement au circuit imprimé (15).

5. Module de commande électronique selon la revendication 1, **caractérisé en ce que** l'au moins une surface de contact (13a) du circuit imprimé (5), vue dans une direction perpendiculaire au circuit imprimé, est disposée au-dessous de la zone de recouvrement (50) de la portion de contact (35) et de la portion de raccordement (25).

6. Module de commande électronique selon la revendication 1, **caractérisé en ce que** la portion de contact (35) de l'au moins une barrette métallique (34) et la portion de raccordement (25) de l'au moins un élément de raccordement (24) sont formées par des bandes métalliques ayant une section transversale rectangulaire qui sont disposées en reposant à plat l'une au-dessus de l'autre, au moins dans la zone de recouvrement (50).

7. Procédé de fabrication d'un module de commande électronique, notamment d'un module de commande pour une commande de boîte de vitesses, comprenant les étapes suivantes :
- fourniture d'un circuit imprimé (5) ayant un côté d'implantation (17) sur lequel est disposée au moins une surface de contact (13a),
- application d'un matériau électriquement conducteur (42) sur l'au moins une surface de contact (13a),
- disposition d'au moins un adaptateur (30) sur le circuit imprimé (5), l'au moins un adaptateur (30) possédant un corps de maintien (31) destiné à la fixation au circuit imprimé (5) à l'extérieur de l'au moins une surface de contact (13a) et au moins une barrette métallique (34) disposée au niveau du corps de maintien (31) avec une portion de contact (35) qui suit un tracé parallèle au côté d'implantation (17) du circuit imprimé (5) au moins dans la position finale fixée sur le circuit imprimé de l'adaptateur (30), l'au moins une barrette métallique (34) étant disposée directement au-dessus de l'au moins une surface de contact (13a) pourvue du matériau électriquement conducteur (42),
- disposition d'au moins un composant électrique (20) sur le circuit imprimé (5) pourvu de l'au moins un adaptateur (30), l'au moins un composant électrique (20) possédant au moins un élément de raccordement (24) qui possède une portion de raccordement (25) qui suit un tracé parallèle au côté d'implantation (17) du circuit imprimé (5), la portion de raccordement (25) étant disposée en reposant directement sur la portion de contact (35) dans une zone de recouvrement (50),
- soudage de la portion de raccordement (25) avec la portion de contact (35), le matériau électriquement conducteur (42) étant une brasure et pendant l'étape de soudage de la portion de raccordement (25) avec la portion de contact (35), la portion de contact (25) étant brasée simultanément avec la surface de contact (13a) par l'apport de chaleur de l'opération de soudage.

8. Procédé de fabrication d'un module de commande électronique, notamment d'un module de commande pour une commande de boîte de vitesses, comprenant les étapes suivantes :
- fourniture d'un circuit imprimé (5) ayant un côté d'implantation (17) sur lequel est disposée au moins une surface de contact (13a),
- application d'un matériau électriquement conducteur (42) sur l'au moins une surface de contact (13a),
- disposition d'au moins un composant électrique (20) sur le circuit imprimé (5), l'au moins un composant électrique (20) possédant au moins un élément de raccordement (24) qui possède une portion de raccordement (25) qui suit un tracé parallèle au côté d'implantation (17) du circuit imprimé (5), l'élément de raccordement (24) étant disposé directement au-dessus de la surface de contact (13a) pourvue du matériau électriquement conducteur (42),
- disposition d'au moins un adaptateur (30) sur le circuit imprimé (5) pourvu de l'au moins un composant électrique (20), l'au moins un adaptateur (30) possédant un corps de maintien (31) destiné à la fixation au circuit imprimé (5) à l'extérieur de l'au moins une surface de contact (13a) et au moins une barrette métallique (34) disposée au niveau du corps de maintien (31) avec une portion de contact (35) qui suit un tracé parallèle au côté d'implantation (17) du circuit imprimé (5) au moins dans la position finale fixée sur le circuit imprimé de l'adaptateur (30), la portion de contact (35) étant disposée dans une zone de recouvrement (50) en reposant directement sur la portion de raccordement (25),
- soudage de la portion de contact (35) avec la portion de raccordement (25).

9. Procédé selon la revendication 8, **caractérisé en ce qu'**avant l'étape de disposition de l'au moins un adaptateur (30), l'au moins un élément de raccordement (24) est relié à la surface de contact (13a) par fusion de matières au moyen du matériau électriquement conducteur (42).

10. Procédé selon la revendication 8, **caractérisé en ce que** le matériau électriquement conducteur (42) est une brasure et **en ce que** pendant l'étape de soudage de la portion de contact (35) avec la portion de raccordement (25), l'au moins un élément de raccordement (24) est brasé simultanément avec la surface de contact (13a) par l'apport de chaleur de l'opération de soudage.
